**Europäisches Patentamt**

**European Patent Office**

**Office européen des brevets**

(19)

(11) Publication number: **0 038 865**

**A1**

(12)

# EUROPEAN PATENT APPLICATION

(21) Application number: **80102220.3**

(22) Date of filing: **25.04.80**

(51) Int. Cl.³: **G 11 C 11/23**
**G 11 C 13/08, G 11 C 13/04**

(43) Date of publication of application:
**04.11.81 Bulletin 81/44**

(84) Designated Contracting States:
**BE CH DE FR GB LI NL**

(71) Applicant: **Christensen, Alton Owen Sr.**
**1540 Diel Drive**
**Milpitas California(US)**

(72) Inventor: **Christensen, Alton Owen Sr.**
**1540 Diel Drive**
**Milpitas California(US)**

(74) Representative: **Fisher, Bernard et al,**
**Raworth, Moss & Cook 36 Sydenham Road**
**Croydon Surrey CR0 2EF(GB)**

(54) **Electron beam accessed read-write-erase random access memory.**

(57) An electron beam storage device is disclosed. A beam impinges on a target (16). The target (16) stores data and it can be read as needed. The target (16) is made of multiple layers, from the top, a first layer (50) of thin conductive metal, and a semiconductor (52) joined to it to define a Schottky diode. The beam liberates ionized pairs in the semiconductor (52). This is joined to an adjacent layer (56) of dielectric and there is another layer (58) of dielectric. The charge in the semiconductor (52) causes tunneling across the first dielectric (56) into the second (58) where it is held. A bottom layer (60) of metal serves as a gate and terminal for bias voltages. The beam is directed to selected X-Y locations to store data, and read in the same manner.

EP 0 038 865 A1

./....

FIG. 1

1

This apparatus is directed to an electron beam accessed random access memory which is capable of reading, writing and erasing information stored in a binary state. One such device is described by literature of the General Electric Company. Another such device is described in Applied Physics Letters, Volume 16, No. 147, (1970) by Hunert et al. In these, the electron beam subjects the metal-oxide-semiconductor (MOS) memory dielectric layer to an excessive fluence of electrons over a period of time, damaging the dielectric layer and destroying the ability of the MOS memory target to both store and read stored information. Depending on the electron beam current and the repetition of read and write cycles, the integral of the electron beam fluence ultimately produces ionizing radiation and physical damage which prohibits further reading, writing and erasing. Thus, the memory target life cycle of both prior art devices is severely limited. The lifetime of data stored is limited in that charges also accumulate during reading so that after a few readings, data is no longer distinguishable and must be erased and written again. Such devices are limited in the number of bit storage density. Relatively thick layers of the MOS target must be penetrated by high energy electrons and scattering of the beam occurs. Furthermore, the source of electrons in the prior art devices are similar to Cathode Ray Tubes (CRT) and have their size, power supplies, focus and beam deflection systems. The

2

devices of the prior art customarily use a junction diode as the output device and not a Schottky diode which has at least twice the gain. Furthermore, the prior art devices do not allow selective erase or overwrite of stored data of both polarities, and they must totally erase an entire storage array while this invention allows selective overwrite or erase at a normal reading cycle. Thus, the beam accessed storage devices of the prior art are capable of only a few reading and writing cycles, have shorter storage life, have less than optimum storage density, cannot selectively overwrite or erase data stored both polarities, are of large physical size, require higher power for operation, produce only a single bit per random access and require multiples for parallel bit access, and cannot be manufactured by economic semiconductor-type batch processes.

3

The present invention is an electron beam accessed random access memory. Data storage sites are delineated only by repeatable X - Y beam positions. The present invention is comprised of an array of field emission microcathodes each having focusing and deflection electrodes, and an array of memory target areas.

The memory target is comprised of five layers: the top is a thin layer of metal conductor and the second is a semiconductor which together form a Schottky diode; the third is a thin layer of dielectric, the fourth is a thicker dielectric layer, and the fifth layer is a thicker metal layer, which is the gate terminal of the target. N by N storage areas in M by M targets may be read at the same time, allowing fast parallel reading and writing. Erasing of data is accomplished by overwriting individual storage areas, or in bulk by application of a significiantly higher potential to the storage area gate.

The thin dielectric layer is sufficiently thick to prevent data loss from the thicker dielectric layer by thermal tunneling of captured charges. The reading electron beam current is insufficient to create the field necessary for tunneling of charges through the thin dielectric and data life is therefore long.

Fig. 1 is a cross sectional view of the field emission cold cathode, the X-Y defection plates, and the target, all of which are in a sealed container;

Fig. 2 is a sectional view through the target of the present invention showing the various layers which comprise the target;

Fig. 3 is a schematic diagram of an amplifier for obtaining an output signal from the target;

Fig. 4 is a timing chart showing output signals relative to the signals applied to the X-Y deflection system;

Fig. 5 is a timing chart showing the relative voltages for the read and write modes of operation and also showing how data is input to the device;

Figs. 6, 7, 8 and 9 are steps in the one manufacturing process of a combined solid state focusing lense and deflection plate system for directing the electron beam toward a specified location; and

Figs. 10, 11 and 12 are steps in one manufacturing process of a target for beam storage and reading of data.

The Assembly As a Whole

The electron beam accessed memory 10 is formed of three major assemblies. The first is a field emission cold cathode 12. The second assembly 14 is a set of deflection plates and focusing lense. The third assembly is a semiconductor target 16. A beam of electrons is emitted by the cathode assembly 12 with one amplitude if digital data is to be read and a larger amplitude to write. The beam is shaped at an aperture, and the deflection plates 14 direct the beam to a certain bit in the target to store the data and provides output signals when read. The target 16 is divided into individual bit storage areas which have a typical dimension of about 0.15 microns diameter. The target area is a square of N by N dimensions where N is a whole number integer and typically a power of 2. The target is a layered device which forms a charge trap between specified layers. When a specific charge is present, a binary one is written into memory. When the charge is absent or of opposite polarity, a binary zero is written. The charge can be read by scanning with a read beam which forms a binary output current flow through a Schottky diode. The beam formed by the cathode circuit 12 is focused on a particular point (an X-Y address) to relate the output signal to the address. The apparatus is enclosed in a hermetically sealed container 18.

Going now to the emitter for the electron beam, it is preferably constructed in the manner described in the works of Charles A. Spindt in an article found in the Journal of Applied Physics, v. 39, No. 7, June 1968, pp. 3504-3505, "A Thin-Film Field-Emission Cathode", and is also described in his patent 3,789,471, and other patents in his name.

As described in the patents of Spindt, a substrate 19 is formed of a suitable metal or non-metal. If metal, one suitable choice is a sheet of molybdenum. Alternately, a plate of aluminum oxide coated with a film of molybdenum may be used. It is preferably conductive or at least semiconductive. The numeral 20 identifies an exposed radiation point. It is preferably conical or pyramidal in shape with a pyramid height of about 0.6 mil. The pyramid is formed of insulating material or of composite materials where the surface is coated or otherwise treated to obtain the desired emission characteristics.

An insulated spacer 21 on the substrate 19 supports a screen 22 with an aperture 23 centered around the point of the exposed electrode 20. The layer 21 is an insulator between the substrates 19 and 22. The substrate 22 is charged positively with respect to the electrode 20 by a voltage across the substrates 19 and 22 to produce a high electric field at the electrode point 20. Negative charge accumulates on the point and emits electrons from the point focused into a beam by the electric field. A power supply 25 is connected between the substrates 19 and 22. The numeral 26 identifies a read/write modulator. When a binary data is to be read, the modulator 26 provides no additional voltage to the potential difference between the substrates 19 and 22. When binary data is to be written, the voltage is increased, thereby increasing the current flow in the electron beam. The writing current is about 100 times larger than the read current.

The beam is accelerated by a additional power supply 27 between the electrode 20 and the target 16 which determines the energy and penetration of the beam. The same accelerating
voltage is used for reading and writing the data stored in the
target 16. A read-write modulator 28 is connected to the target
16 to modulate the data. The accelerating voltage is typically
in the range of 4,000 to about 6,000 volts. For writing, the
beam current is increased dependent on the dwell time, thickness,
distance from the electrode 20, size of the target bit location,
and other factors.

The beam deflector 14 includes X and Y axis deflector
plates. Plates for the X voltage 31 and 32 are spaced at
opposite sides of the beam. The Y plates 33 and 34 are at right
angles to the X plates. All are preferably formed on dielectric
substrates drilled with a relatively small hole approximately
one to five microns in diameter. Metalized, spaced, parallel
electrodes are used in the same fashion as in a cathode ray tube
with the deflection plates 31 - 34 supported on substrates with
conductive pads geometrically arranged adjacent to the hole. The
pads are electrically isolated by an intermediate dielectric
substrate. A focusing aperture including a concentric conductor
around the axial hole and about 10 or 15 microns in diameter is
acceptable. A circular conductive ring electrified to about
three to thirty volts difference to the substrate 19 directs the
beam through the aperture and the deflection plates. The
focusing ring and deflection plates are formed in multiple layers
which have a thickness depending upon the deflection and target distance.

The target 16 includes multiple locations for storage of data bits. The deflection plates position the electron beam to the various locations so that reading, writing, or erasing, as necessary, may occur. The target 16 thus defines a mass memory device which is organized on a N by N pattern. A suitable spacing to the target 16 is one or two centimeters or more if the target array is larger. Given maximum deflection angle, an increase in target size (more bits storage capacity) requires a greater distance. Representative dimensions are up to about 512 X 512 individual bit storage areas, (a circular storage area) about 0.15 microns in diameter to define a rectangular target of about 75 X 75 microns. In view of spacing at one or two centimeters, the deflection angle is relatively small.

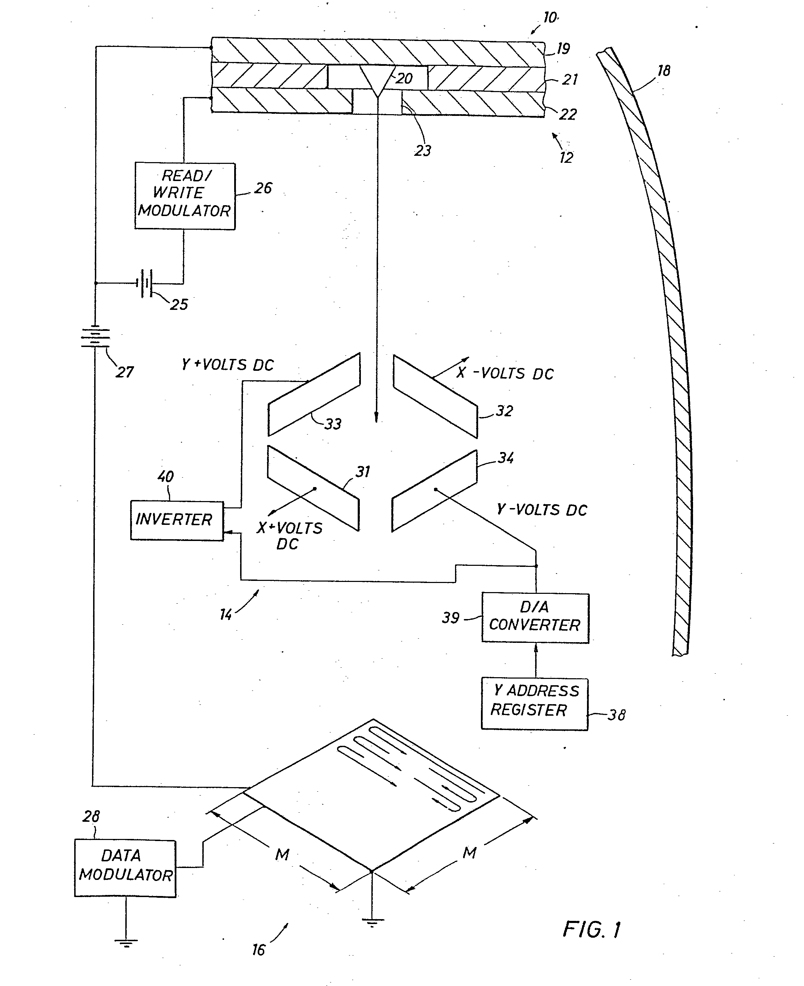

If the target has a dimension of 512 bits, then a nine bit words, ignoring parity, will describe uniquely each particular target location. Fig. 1 incorporates a Y address register 38 to receive and hold a Y address of nine bits. The Y address is input to a digital to analog converter 39, to form an output voltage applied to the plates for the Y axis, thus deflecting the beam. An inverter 40 applies the voltage from the converter 39 to the opposite plate.

Target Description

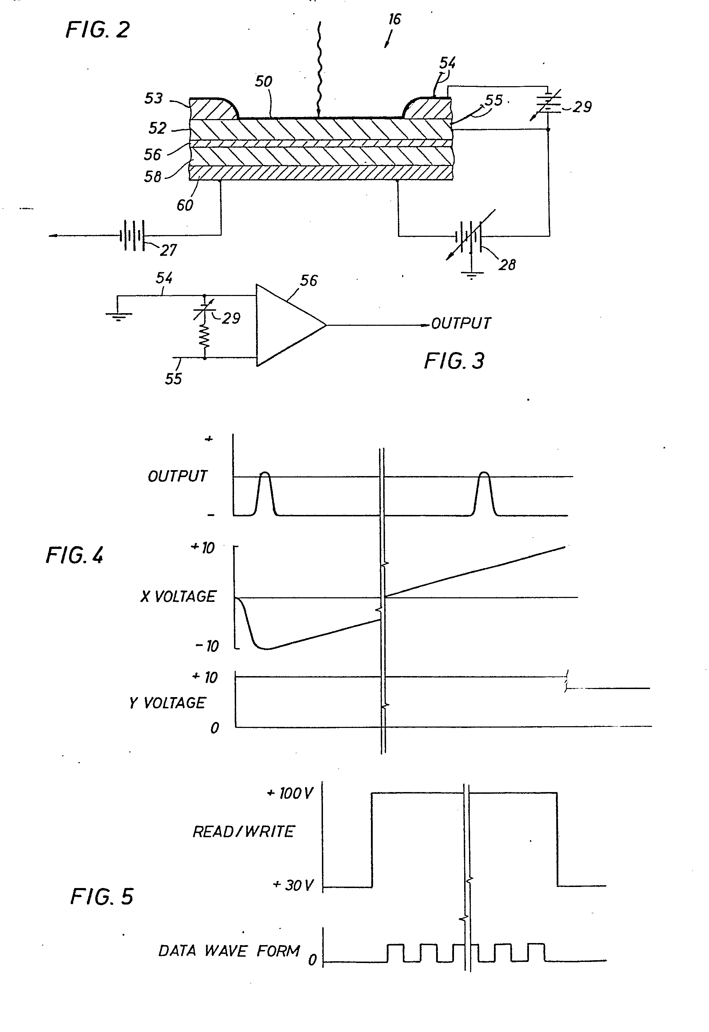

Going now to Fig. 2 of the drawings, the target 16 is shown in an enlarged sectional view. The target 16 is uniformly constructed across the entire area of N by N. The target 16 is positioned perpendicular to the undeflected beam. It has the N by N bit locations distinguished one from another only by physical location. They are not mechanically isolated from one another. The description proceeding from the top down relates the function of the various layers in the target 16 to the electron beam which impinges upon it.

On the top, a relatively thin conductor layer 50 is preferably aluminuim about 250 angstroms thick. This layer functions as one of the terminals of a Schottky diode with the doped silicon layer therebelow. The beam penetrates the aluminum layer 50. The conductor is preferably thin and of low density to minimize scattering of the electron beam.

Each bit location is about 0.15 microns in diameter. The entire aluminum layer forms a single diode but it is beam activated only at one bit location at a time. Accordingly, it is appropriate to speak of a single diode at each bit location which diode has a diameter of about 0.15 microns. The relatively thin aluminum deposition is laid over a silicon semiconductor layer 52. The layer 52 is relatively thick, in the range of 500 to 1500 angstroms thickness with N type or P type impurities. The preferred embodiment is N type. The amount of doping is about 10 to 10 per cubic centimeter. The dopant concentration is less than that which would allow tunneling across the diode depletion region, but sufficient to cause a low diffusion coefficient. It is sufficient to create the Schottky diode in conjunction with the metal deposition on the top surface. The dopant selected is any of those customarily used for obtaining N or P doping.

The numeral 53 identifies a dielectric insulator such as silicon nitride or aluminum oxide which borders around the target 16. It adds a rim or border which lends mechanical strength to the structure. Moreover, it defines the outer limits of the target. It has nothing to do with the storage of data in the target. It merely indicates the limits of the target and also limits the area where the Schottky diode is constructed. its width is also immaterial and need not enter into consideration.

The metalized top layer 50 and the silicon layer 52 extend across the width and length of the target 16 to form a Schottky diode with the terminals 54 and 55. The terminals are inputs for an inverting amplifier. A suitable operating bias voltage is provided across the diode and input terminals of the amplifier.

The numeral 56 identifies a relatively thin silicon dioxide dielectric. The layer 56 is relatively thin, typically in the measure of about 25 angstroms but it can be varied dependent on voltages.

The numeral 58 identifies a suitable dielectric layer preferably formed of silicon nitride or aluminum oxide, and has a thickness of about 300 to 500 A°. This range of thickness defines a suitable polarizing field for charges which are held in this layer as described. The layer has low mobility of charges to isolate adjacent bit storage locations. The bottom most layer 60 is a relatively thick aluminum gate structure one micron or more thick. It is fairly thick to define a supporting base or foundation for the comparatively thin layers which are carried on it. It also serves as an electrical terminal connected to the voltage source 28 for data modulation and a source 27 for acceleration purposes. The accelerating potential and the read/write wave form are applied to the gate 60.

Consider the target 16 in three operations writing of a binary one, writing of a binary zero, and reading of the data.

Preferably, the beam is accelerated to about 5000 electron volts (ev) with a current flow that is in the range of about one nanoampere. When the beam enters the layer 50, a certain portion of the energy is dissipated, less than 2000 electron volts (ev) of energy is dissipated in that layer. This then leaves the electron beam with an energy level of about 2000 to 4000 ev to dissipate within the silicon layer. When each electron strikes the silicon layer, it ionizes a charged pair, namely an electron and a hole for each 3.6 ev of energy dissipated and an adequate number of charged pairs is liberated in the silicon layer 52.

Prior to the introduction of the electron beam into the silicon layer 52, two fields exist. The first field extends across the depletion region of the Schottky diode into the silicon layer 52. The field width into the silicon layer 52 is controlled by the bias supply 29. Assuming N-doped silicon, the negative terminal of supply 29 is connected to the diode at terminal 54, and the positive terminal of supply 29 is connected to the silicon at terminal 55. The second field exists between the surface of the silicon 52 and its interface with dielectric layer 56. The existing surface charges resulting from unsatisfied bonds, contaminants, mechanical discontinuities, and charges captured near the interface between dielectric layers 56 and 58 cause surface charges of the silicon to be accumulated, and therefore the conductivity at the surface is greater than in the bulk of silicon layer 52. In the preferred embodiment the Schottky diode field is depleted of electrons and the silicon surface near the interface with dielectric layer 56 is accumulated with electrons.

When the energy of the beam of electrons is expended in the silicon 52 and its depletion region, the charge multiplication created by the ionization process both produces a field in the semiconductor and results in a current amplification in the semiconductor, increasing the current in the semiconductor by two orders of magnitude or more over the amplitude of the electron beam current. The ionized charges created by the exhaustion of the electron beam energy are separated by the fields in the semiconductor. The beam of electrons is a virtual electrode in the semiconductor have a polarity which is a function of the polarity and magnitude of the supply 28 connected between the gate 60 and semiconductor 52. The ionized pairs created in the Schottky diode depletion region of the semiconductor tend to be separated by that depletion region field and drift rapidly, in a few nanoseconds or less, to the corresponding diode ohmic contacts creating particle and displacement currents which appear in the load circuit at the input to the amplifier. Charge pairs created in the semiconductor-gate field, of which the energy-exhausted electron beam is one terminal, in combination with the polarizing bias supply 29, are separated by that field and tend to recombine with opposite polarity charges at the semiconductor-dielectric interface, or, in the high field conditions of the writing mode, are accelerated by the high field and tunnel across the thin dielectric layer 56, and are captured near the interface between dielectric layers 56 and 58. Conversely, charges of opposite polarity previously captured near that interface can be caused by the high writing field to tunnel back through to the silicon, thus overwriting or erasing previous data.

Bit Storage Density

Lateral diffusion or spreading of charges, affecting data storage density, is controlled by the thickness and conductivity of the semiconductor. High semiconductor conductivity and thin film of the semiconductor produces low diffusion coefficient of the charges and minimal spreading, particularly in the silicon accumulation region near the semiconductor-dielectric interface where conductivity is the highest. The thickness of the semiconductor 52 for a given semiconductor material, doping density and electron beam energy, is made to satisfy four criteria: Firstly, that the electron beam energy is exhausted in the semiconductor before reaching the dielectric layer 54; secondly, that sufficient electron beam energy is exhausted in ionization of charge pairs to produce the current amplification required for either writing or reading operations; thirdly, that the semiconductor layer 52 is thin enough to create the bit area storage density desired; and fourthly, that the Schottky diode depletion into the semiconductor is sufficient to withstand the field created in the semiconductor. Current amplification occurs as the energy of the beam is exhausted in the semiconductor. The average depth of penetration is a function of the semiconductor density. For silicon semiconductors, and an energy of 4Kev, the average penetration is about 2200 Angstroms. An average of 4000/3.6 or 1250 charge pairs would be created per electron by ionization. Since 2200 Angstroms is the average depth, the silicon layer 52 should have such additional thickness to prevent electrons from reaching dielectric layer 54 to avoid ionization and consequent cumulative fixed charge creation in that dielectric. For a small diameter electron beam, 600 Angstroms mean diameter or less, charge pair diffusion rather than beam spreading is the major factor affecting bit storage location density. The effectual diffusion of created charges occurs outside of the Schottky diode depletion region field within the semiconductor, between the depletion region edge and the semiconductor-dielectric interface. The width of the depletion region into the semiconductor is controlled by bias source 29. That undepleted width in the semiconductor should be made less than the desired spacing between bit storage locations so that when reading stored information, the charges created in the semiconductor not recombining at the semiconductor-dielectric surface will be nearer to and more probably captured by the Schottky diode field than diffusing to and recombining at neighboring attractive bit storage locations. The width of the Schottky diode depletion region should be sufficient to support the field created in the semiconductor by the electron beam, the width being adjustable by bias supply 29.

In a writing operation, the bias voltage 28 produces a field which is used to polarize the field created by the electron beam. Since the polarizing field between gate 60 and semiconductor 52 covers the whole N by N area of data storage positions, only one of which is addressed by the electron beam, for proper operation that polarizing potential must meet several criteria: Firstly, the combination of the field created in the

16

semiconductor and the gate to semiconductor fields, including that supplied by the polarizing potential, surface state and dielectric-trapped charges, must be sufficient to both select the polarity of and cause tunneling of the charge across dielectric 56 into dielectric 58. Secondly, the field produced in the remaining N by N storage areas by the polarizing potential of supply 28 must not be sufficient to cause tunneling of charges in those non-addressed locations. The field produced by the polarizing supply 28 is a function of the potential and the thicknesses of dielectric layers 56 and 58. For example, if we assume nominal values for both previously written charges and for surface state charges, and 2.5 nanometers thickness for dielectric layer 56 of silicon dioxide, and 35 nanometers thickness for dielectric layer 58 of silicon nitride, then the potential applied by source 28 should not exceed 5 volts. The remaining field requires about 7.6x10 v/cm or about 1.9 volts across the 2.5 nanometer thickness of dielectric 56, must be supplied by the field created in the semiconductor by the electron beam. In a reading or off condition, the gate electrode 60 is placed at the same potential as the semiconductor 52. When the gate electrode is made positive with respect to the semiconductor in a writing operation, electrons are caused to tunnel across dielectric 54 into dielectric 56 and combine with holes in that dielectric, or to be captured, resulting in less surface accumulation and higher recombination velocity in a subsequent reading operation. When the gate electrode 60 is made negative with respect to the semiconductor potential in a writing operation, holes recombine at the surface and are caused to tunnel through dielectric 54 into dielectric 56, and be captured, or electrons caused to tunnel back through dielectric 54 producing greater surface accumulation and a lower surface recombination velocity in a subsequent reading operation.

The charge near the dielectric-dielectric interface prior to any operations, and due to manufacturing processes can be varied monotonically increasingly positive at deposition temperatures for silicon nitride bvelow about 850° C, and increasingly negative at temperatures about 850° C.

Summary of Writing Operations

To write a binary zero, the following conditions must occur:

1. The desired single position of the N by N possible positions is input in binary form to the X and Y address registers 38, converted into an analog voltage for the X and Y coordinates of the address by digital-to-analog converters 39, connected to deflection plates 31-32 and 33-34 respectively, which analog voltages cause the beam of electrons to be positioned at the selected location.

2. The read/write modulator 26 must be in the write condition, supply the higher voltage as indicated in Figure 5 to the field emission cathode to produce the nigher, writing beam current and consequently sufficient field in the semiconductor to cause tunneling and capture of charges across dielectric 56 into dielectric 58.

3.    In some designs it may be necessary to change the potential supplied by 29, across the Schottky diode terminals 54,55, to effect a change in the diode depletion width into the semiconductor, which width would differ in the reading and writing operations.  In such a design, a read/write signal of the same timing but of a differing sufficient amplitude and polarity would be applied as a portion of bias source 29 to effect the desired change.

4.    The data modulator must be in the positive, binary one, state of the data waveform, Figure 5, applying a positive voltage from gate 60 to semiconductor 52, polarizing the electron beam locally created field in the semiconductor and causing electrons to tunnel across dielectric 56 and be captured in dielectric 58 or combine with holes in dielectric 58.  When the data voltage returns to the same potential as the semiconductor, the reading condition, and when the electron beam field is reduced to the reading level, the tunneled charges are frozen in, and result in less surface accumulation and higher surface recombination velocity.

To write a binary one, the following conditions must occur:

1.    Conditions 1, 2 and 3 are the same as for writing a binary zero.

2.    The data modulator must be in the negative, binary zero, state of the data waveform, Figure 5, applying a negative voltage from the gate 60 to semiconductor 52, but not so negative as to produce an inversion layer in the semiconductor, said negative voltage being sufficient to polarize the electron beam created field in the semiconductor and causing holes to tunnel across dielectric 56, or electrons to tunnel back across dielectric 56, resulting in charges being frozen in when the gate voltage is returned to zero volts with respect to the semiconductor potential.

Reading Operation

The same accelerating voltage is used as in writing. The read/write modulator 26 is set to read, the low voltage condition of Figure 5, reducing the electron beam current to 1/100 of the current used for writing, about 10 picoamperes, insufficient to cause tunneling. The beam is positioned to the desired storage location.

The reading beam current is amplified, as in the case of writing, by ionization of a multiplicity of charge pairs. The excess holes created must either recombine at the semiconductor surface near the interface with dielectric 56, or be captured by the field of the Schottky diode. The insignificant number of holes recombining in the bulk silicon can be neglected. The charge pairs created in the semiconductor near the semiconductor-
dielectric interface are affected by the surface recombination
velocity. As the surface recombination velocity increases, fewer
and fewer holes are captured by the field of the diode and more
and more of the excess holes created by the reading beam
recombine at the surface. A stored binary one corresponds to
high recombination velocity, and a stored binary zero corresponds
to low, near zero, recombination velocity. If a binary zero is
read, nearly all excess holes will be captured by the field of
the diode and appear as a modulation on the output current
between terminals 54 and 55. A positive voltage corresponds to a
binary one, and a ground potential corresponds to a binary zero.

Manufacturing Process

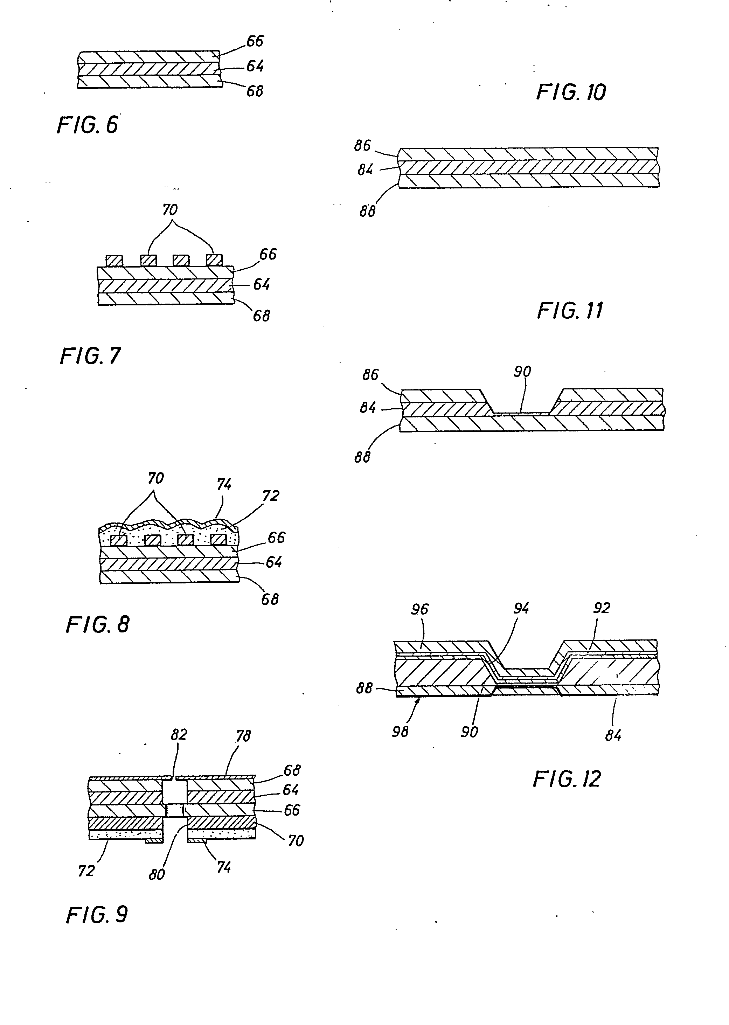

A series of manufacturing steps are shown in Figs. 6-9
is a method of manufacturing serveral cold emission cathodes and
deflector plates. The next manufacturing process to be described
is one suitable for manufacture of the target 16 having a first
layer of metal, a second layer of semiconductor, third and fourth
layers which differ in thickness and which are dielectric layers,
and a bottom layer which is a conductive metal substrate or gate.
Connective pads around the periphery for connecting suitable bias
voltages to the Schottky diode and between the semiconductor and
the metal substrate.

Through the use of chemical or plasma discharge
techniques, a wafer of suitably doped silicon is thinned to a thickness of about ten microns or less. The actual thickness is dependent on the target area width desired and whether or not subsequent edging techniques are anisotropic. Fig. 10 is representative of this and depicts silicon layer 84 with grown oxide thicknesses 86 and 88 on both surfaces. Photolithographic techniques define areas to be etched away. Etching utilizing protoresist proceeds and etch pits are formed as shown in Fig. 11. A membrane is formed about two microns thick in the silicon layer 84 in the etch pit 90. Fig. 11 presupposes that an anisotropic process is used. Thereafter, through the use of chemical or plasma cleaning techniques, the remaining silicon dioxide layer 86 is removed and the wafer is cleaned.

The next step is to grow about 25 A° of clean silicon dioxide 92 on the wafer at a relatively low temperature, typically about 600° C or lower. The next step is then to deposit silicon nitride 94 at a temperature of about 700° C. The exact temperature, whether about or below a specified temperature (usually 700° C), depends on the magnitude and sign of the charges desired to be trapped or eliminated from capture near the oxide/nitride interface. This layer 94 has thickness in the range of about 350 to 500 angstroms. The preferred thickness is about 450 A°. Contact holes are formed through the successive layers to enable connection with the strata of the device. The semiconductor layer in the pit 90 may be chemically exposed on the lower side to permit ion implantation for the purpose of altering the resistivity of the silicon to enable ohmic contact. Thereafter, a suitable conductor 96, typically aluminum, is deposited to a tickness of 10 microns or greater.

Fig. 12 shows four layers adjacent to the etch pit 90 as  shown in Fig. 2 except, however, the connections are omitted and the top metal surface has not yet been applied.  The silicon substrate 84 is inverted and through the use of photolithographic techniques, suitable patterns are formed on the face (now the top face).  The exposed silicon is then etched to the final desired thickness so that the surplus portion can be removed.  Surplus provides adequate mechanical structure in the fabrication.  After the face of the wafer 84 has been etched, then aluminum or some other low density conductor material 98 is sputtered or otherwise deposited to a thickness of about 20 to 25 nanometers normally from above upon inverting the silicon wafer.  The five layers of the target are now defined and scribed into dice of suitable sizes.

In any case, the foregoing is directed to the preferred embodimentbut the scope thereof is determined by the claims.

BAD ORIGINAL

1

CLAIMS

1. An electron beam storage apparatus comprising:

(a) an electron beam source which forms an electron beam directed toward a target;

(b) a target which is formed of a semiconductor into which the electron beam is directed forming ionized charged pairs therein, and further incorporating a dielectric adjacent to said semiconductor which dielectric stores charges therein from said adjacent semiconductor; and

(c) an accelerating voltage source connected to spaced terminals for applying an accelerating voltage for imparting energy to electrons of the electron beam sufficient to penetrate into said semiconductor, but which energy level is not sufficient to penetrate through said semiconductor to said dielectric layer.

2. The apparatus of Claim 1 including at least a pair of electron beam sources and at least a pair of targets similarly constructed, each target being assigned to a specific beam source.

3. The apparatus of Claim 1 wherein the dielectric and semiconductor of said target have planar extent with adjacent but separate bit storage areas defined by the charge mobility of charges in said dielectric.

2

4. The apparatus of Claim 1 wherein the dielectric is formed of first and second adjacent dielectric layers and charges from said semiconductor are stored in the second layer after tunneling through the first dielectric layer, and said first dielectric layer is sufficiently thick to prevent random tunneling therethrough absent a field above a specified potential across said first dielectric layer.

5. The apparatus of Claim 8 including a bias voltage source and terminals for applying the bias voltage across said first dielectric to produce a field across the dielectric layer above the specified potential sufficient to cause tunneling across said dielectric layer.

6. The apparatus of Claim 1 including means for altering current in said electron beam between a read current and a write current wherein said write current is larger and said write current, when impinging on said target, forms ionized electrons and holes in said semiconductor which are electrostatically separated and one is attracted to a preexisting charge in said dielectric.

7. The apparatus of Claim 1 wherein said electron beam source is modulated by a modulating means to form different beam currents for reading and writing and which forms in the target a field sufficiently large that a data bit is written by localized tunneling from the semiconductor into the dielectric, and which field, on reading, is not sufficient to cause tunneling into the dielectric.

3

8. The apparatus of Claim 1 wherein said target area is defined along a pair of perpendicular dimensions to include multiple bit storage locations which data bit storage locations are in said dielectric and are isolated from one another by a distance which, in conjunction with the mobility of the charges in lateral movement within said dielectric, thereby defines isolated adjacent locations, there being an interface charge barrier between said semiconductor and said dielectric layer causing the surface at said semiconductor adjacent to said dielectric to accumulate charges where the extent of accumulation is increased in the area adjacent to data bit locations storing majority carriers.

9. The apparatus of Claim 1 including a conductor affixed to said semiconductor opposite to said dielectric layer to define a Schottky diode thereat which functions as a Schottky output diode for the multitude of bit locations which diode forms output signals from carriers created in said semiconductor by said electron beam.

10. For use with an electron beam accessed storage device, a solid state memory therefor which is formed of generally coplanar and coterminous layers which layers are respectively a conductor, a semiconductor, a first dielectric, a second dielectric, a conductor and an electron beam source positioned to direct an electron beam at the first named conductor layer which beam impinges on said solid state memory by passing through said first named conductor layer.

0038865

FIG. 1

FIG. 2

FIG. 3

OUTPUT

FIG. 4

OUTPUT

+10

X VOLTAGE

−10

+10

Y VOLTAGE

0

FIG. 5

+100 V

READ/WRITE

+30 V

DATA WAVE FORM    0

FIG. 6

FIG. 7

FIG. 8

FIG. 9

FIG. 10

FIG. 11

FIG. 12

| DOCUMENTS CONSIDERED TO BE RELEVANT | | | CLASSIFICATION OF THE APPLICATION (Int. Cl.³) |
|---|---|---|---|
| Category | Citation of document with indication, where appropriate, of relevant passages | Relevant to claim | |
| | US - A - 3 763 476 (GENERAL ELEC-TRIC COMPANY)  <br> * Column 2, line 56 - column 3, line 36; figure *  <br><br> -- <br><br> PROCEEDINGS OF THE IEEE, vol. 63, no. 8, August 1975, pages 1230-1240 <br>New York, U.S.A. <br>W.C. HUGHES et al.: "A semiconductor nonvolatile electron beam accessed mass memory" <br><br> * Page 1230, right-hand column, line 6 - page 1231, right-hand column, line 26; figure 2 * <br><br> ----- | 1 <br><br><br><br><br> 1 | G 11 C 11/23 <br> 13/08 <br> 13/04 <br><br><br><br><br> TECHNICAL FIELDS SEARCHED (Int. Cl.³) <br><br> G 11 C 11/23 <br> 13/08 <br> 13/04 |

CATEGORY OF CITED DOCUMENTS

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

The present search report has been drawn up for all claims

| Place of search | Date of completion of the search | Examiner |
|---|---|---|
| The Hague | 20-01-1981 | DEGRAEVE |

EPO Form 1503.1  06.78